# EUROPÄISCHE PATENTSCHRIFT

(11) **EP 0 630 479 B1**
(45) Veröffentlichungstag und Bekanntmachung des Hinweises auf die Patenterteilung: **27.12.1995**
(21) Anmeldenummer: 93905167.8
(22) Anmeldetag: 08.03.1993
(51) Int. Cl.: G01R 15/08, G01D 3/00, H01R 29/00

(54) **ANORDNUNG ZUR MESSBEREICHSANPASSUNG**
MEASURING RANGE ADAPTER
DISPOSITIF POUR ADAPTER DES PLAGES DE MESURE

(30) Priorität: 11.03.1992 DE 9203297 U
(43) Veröffentlichungstag der Anmeldung: 28.12.1994
(73) Patentinhaber: SIEMENS AKTIENGESELLSCHAFT, 80333 München (DE)
(72) Erfinder: NICKLIS, Rainer, D-76835 Gleisweiler (DE)
(86) Internationale Anmeldenummer: DE9300211
(87) Internationale Veröffentlichungsnummer: WO9318411

(56) Entgegenhaltungen:
- DE-A- 2 734 841
- GB-A- 2 181 905

## Beschreibung

Die Erfindung betrifft eine Einheit gemäß dem Oberbegriff des Anspruchs 1.

Aus dem SIEMENS-Katalog ST 54.1, 1990, Kapitel 4, sind Ein- und Ausgabeeinheiten eines Automatisierungsgerätes bekannt. Ein Signalformer, z. B. eine Analogeingabebaugruppe, ist mit vier Steckplätzen zur Aufnahme von steckbaren Modulen versehen, welche die Meßbereiche dieses Signalformers an die Meßbereiche von Prozeßeingangssignalen anpassen. Die Signale werden im Signalformer digitalisiert und zur weiteren Verarbeitung einer Verarbeitungseinheit zugeführt. Für unterschiedliche Meßbereiche, z. B. ± 1 V, ± 20 mA, sind verschiedene Meßbereichsmodule vorgesehen, was sich störend bei der Projektierung eines Automatisierungssystems auswirkt. Ferner ist es nicht möglich, die Signalformer und Module zusammen abzugleichen, da die Module und die Signalformer getrennt gefertigt und geprüft werden und die Projektierung bei der Prüfung nicht bekannt ist.

Aus der GB-A-2 181 905 ist eine Anordnung mit einer Einheit bekannt, welche einen Steckplatz für ein mit Anzeigemitteln versehenes steckbares Modul aufweist. Das Modul ist in die Einheit zur Einstellung verschiedener Pegel unterschiedlich steckbar, wobei die Anzeigemittel anzeigen, in welcher Stellung des Moduls keine Pegeldämpfung bewirkt werden kann. Umständliche Lötverbindungen zur Pegeleinstellung werden vermieden.

Der vorliegenden Erfindung liegt die Aufgabe zugrunde, eine Einheit der eingangs genannten Art zu schaffen, welche eine Projektierung in einem Automatisierungsgerät vereinfacht.

Diese Aufgabe wird durch die im kennzeichnenden Teil des Anspruchs 1 angegebenen Maßnahmen gelöst.

Die erfindungsgemäße Einheit zeigt der Verarbeitungseinheit des Automatisierungsgerätes oder der an das Automatisierungsgerät angeschlossenen peripheren Einheit an, welcher Meßbereich eingestellt ist, wodurch die Verarbeitungseinheit bzw. die periphere Einheit ungestörte Signale von gestörten Signalen unterscheiden kann. Sie kann Signale richtig verarbeiten und Fehler des Signals erkennen.

Der Steckplatz des Signalformers weist eine einfache Eingangsschaltung mit mehreren verbindbaren Meßpunkten auf, die durch Brücken des Moduls entsprechend dem gewünschten einzustellenden Meßbereich kurzgeschlossen werden.

Das Modul ist als Würfel ausgebildet, wobei jede Seitenfläche des Würfels Brücken für einen Meßbereich aufweist.

Anhand eines in der Zeichnung dargestellten Ausführungsbeispiels werden die Erfindung sowie deren Ausgestaltungen und Vorteile näher erläutert.

Es zeigen
- Figur 1: eine Eingangsschaltung für eine Analogeingabe,
- Figur 2: unterschiedliche Meßbereichseinstellungen mit der Eingangsschaltung nach Figur 1,
- Figuren 3 und 4: verschiedene Modulausführungen,
- Figur 5: verschiedene Gebilde von Modulen und
- Figur 6: Kennungen eines Steckplatzes auf einer Analogeingabe.

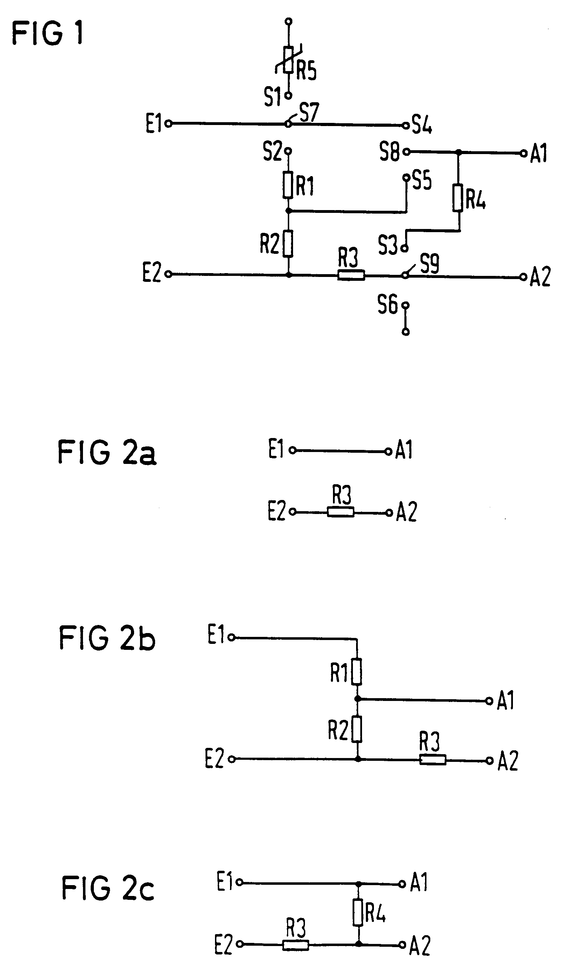

In Figur 1 sind mit S1, S2 ... S9 verbindbare Meßpunkte einer Eingangsschaltung eines Steckplatzes einer Analogeingabe bezeichnet. Diese leitet Eingangssignale an Eingängen E1, E2 über Widerstände R1, R2 ... R5 nach Maßgabe der Brückeneinstellungen an diesen Meßpunkten an Ausgänge A1, A2 weiter. So lassen sich z. B. drei in den Figuren 2a bis 2c dargestellte Schaltungsvarianten für drei unterschiedliche Meßbereiche einstellen. Eine Schaltungsvariante nach Figur 2a wird dadurch bewirkt, daß eine Verbindung der Meßpunkte S7 mit S8 und eine Überbrückung des Meßpunktes S9 hergestellt wird, eine Schaltungsvariante nach Figur 2b durch eine Verbindung der Meßpunkte S2 mit S7, der Meßpunkte S5 mit S8 sowie durch eine Überbrückung des Meßpunktes S9. Eine weitere Schaltungsvariante nach Figur 2c wird durch eine Verbindung der Punkte S7 mit S8 und S3 mit S9 bewirkt.

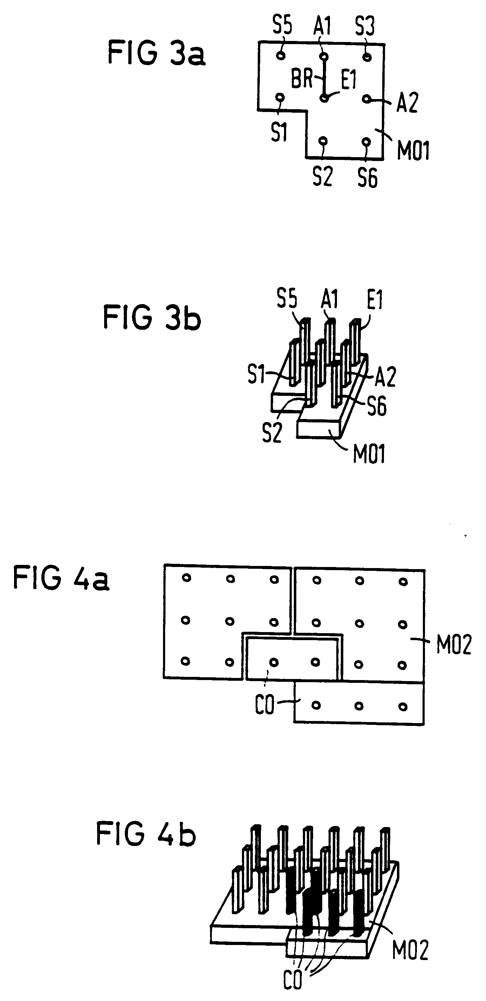

Um die in Figur 2 dargestellten drei Schaltungsvarianten und somit drei Meßbereiche einzustellen, sind in Figur 3 Brücken BR in ein in Kunststoff eingespritztes Modul MO1 entsprechend diesen einzustellenden Meßbereichen zusammengefaßt, Der Übersicht halber ist lediglich eine Brücke BR in Figur 3a eingezeichnet. Weiterhin kann im vorliegenden Beispiel auf die Anschlüsse der Meßpunkte S4, S7, S8 und S9 verzichtet werden, da für die dargestellten Meßbereiche die Punkte S4 und S7 dem Eingang E1 entsprechen, der Punkt S9 dem Ausgang A2 entspricht und der Punkt S8 dem Ausgang A1. In Figur 3a ist das Modul als Buchsenelement mit entsprechenden nicht dargestellten Federkontakten ausgebildet, in Figur 3 als Stiftelement. Entsprechend der Ausführungsform des Steckmoduls als Buchsen- oder Stiftelement ist der Steckplatz der Eingangsschaltung mit Stiften oder Federkontakten versehen. Die drei verschiedenen Meßbereiche können nun durch Verdrehen des Steckmoduls MO1 eingestellt werden, d. h., je nach Lage des gesteckten Moduls auf dem Steckplatz der Eingangsschaltung wird eine der drei möglichen Meßbereichseinstellungen nach Figur 2a, 2b oder 2c bewirkt.

Figur 4a bzw. 4b zeigen wiederum ein als Buchsen- bzw. Stiftelement ausgebildetes Modul MO2 in einer Zweikanal-Ausführung, das mit Codierungsmitteln CO versehen ist. Diese Codierungsmittel CO, die ebenfalls als Stift- oder Buchsenelement ausgebildet sind, zeigen einer hier nicht dargestellten Verarbeitungseinheit an, welcher Meßbereich auf der Eingangsschaltung der Analogeingabe eingestellt ist. Für den Fall einer Analogausgabe zeigen die Codierungsmittel CO einer peripheren Einheit den eingestellten Meßbereich an.

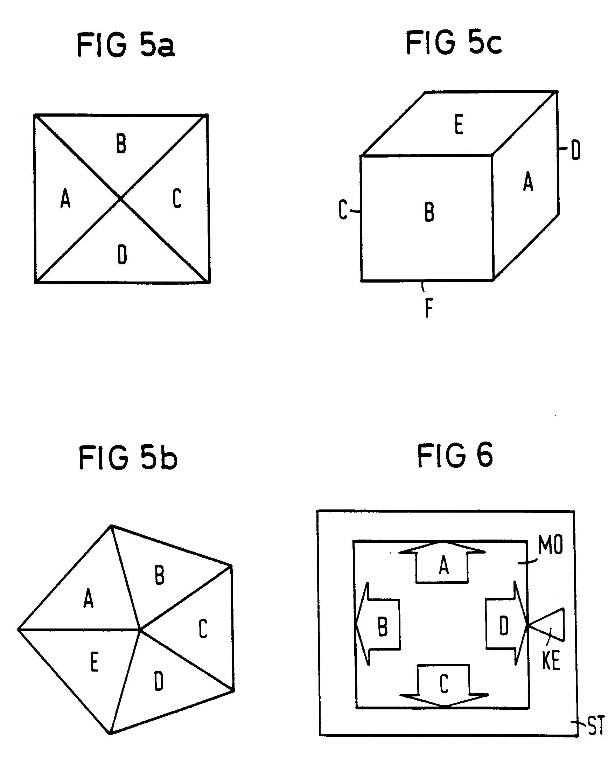

Figur 5 zeigt unterschiedliche Gebilde eines Moduls. Eine Seitenfläche der Module in Figur 5a und 5b ist in mehrere Teilflächen unterteilt, die Brücken für verschiedene einzustellende Meßbereiche aufweisen. In der Ausführung gemäß Figur 5a sind vier Meßbereiche A ... D, gemäß der in Figur 5b fünf Meßbereiche A ... E einstellbar. Figur 5c zeigt ein würfelförmiges Gebilde, wobei jede Seitenfläche A ... F mit Brücken für eine Meßbereichseinstellung versehen ist.

Damit ein Meßbereich einfach eingestellt werden kann, sind die Teil- bzw. Seitenflächen der Gebilde mit Kennungen A, B, C, D (Figur 6) und der Steckplatz ST der Einheit mit einer Kennung KE versehen, um eine leichte Zuordnung zwischen dem gewünschten einzustellenden Meßbereich und der Lage des Moduls auf dem Steckplatz treffen zu können. Im gezeigten Beispiel zeigt die Kennung D des Moduls MO auf die Kennung KE des Steckplatzes ST, was darauf hinweist, daß der der Kennung D zugeordnete Meßbereich eingestellt ist.

## Patentansprüche

1. Einheit, die mindestens einen Steckplatz mit einem mit Codierungsmittel (CO) versehenen steckbaren Modul (MO1, MO2) aufweist, das Signale an eine Verarbeitungseinheit eines Automatisierungsgerätes oder an eine an die Einheit angeschlossene periphere Einheit weiterleitet und auf dem Steckplatz zur unterschiedlichen Meßbereichseinstellung der Einheit unterschiedlich steckbar ist, dadurch gekennzeichnet, daß die Codierungsmittel (CO) der Verarbeitungs- oder der peripheren Einheit den eingestellten Meßbereich anzeigen.

2. Einheit nach Anspruch 1, **dadurch gekennzeich**net, daß das Modul (MO1, MO2) würfelförmig ausgebildet ist, wobei jede Seitenfläche (a ... f) für eine Meßbereichseinstellung vorgesehen ist.

## Claims

1. Unit which has at least one module location having a plug-in module (MO1, MO2) provided with an encoding means (CO), which module passes signals to a processing unit of an automation device or to a peripheral unit connected to the unit, and which can be inserted at the module location in different ways for the variable measuring range setting of the unit, characterised in that the encoding means (CO) indicate to the processing unit or the peripheral unit the measuring range that is set.

2. Unit according to claim 1, characterised in that the module (MO1, MO2) is formed as a cube, wherein each side surface (a ... f) is provided for a measuring range setting.

## Revendications

1. Unité, qui comporte au moins un emplacement d'enfichage ayant un module (MO1, MO2), qui peut être enfiché, qui est muni de moyens (CO) de codage, qui retransmet des signaux à une unité de traitement d'un appareil d'automatisation ou à une unité périphérique connectée à l'unité et qui peut être enfiché de diverses manières à l'emplacement d'enfichage pour régler de diverses manières le domaine de mesure de l'unité, caractérisée en ce que les moyens (CO) de codage de l'unité de traitement ou de l'unité périphérique indiquent le domaine de mesure réglé.

2. Unité suivant la revendication 1, caractérisée en ce que le module (MO1, MO2) a la forme d'un cube, chaque surface (a ... f) latérale étant prévue pour un réglage du domaine de mesure.
